# EUROPEAN PATENT APPLICATION

(11) **EP 4 654 251 A1**
(43) Date of publication of application: **26.11.2025**
(21) Application number: 25177050.9
(22) Date of filing: 16.05.2025
(51) Int. Cl.: H01L 21/60, H01L 21/68, H01L 25/00

(54) **CHIPLET HEAD APPARATUS EQUIPPED WITH X-RAY IMAGING SYSTEM FOR SEMICONDUCTOR PACKAGING ALIGNMENT AND METHOD THEREOF**

(30) Priority: 20.05.2024 KR 20240065088; 16.10.2024 KR 20240141332
(71) Applicant: Korea Atomic Energy Research Institute, Daejeon 34057 (KR)
(72) Inventor: KANG, Chang Goo, Gwangju 62052 (KR); PARK, Jeongmin, Hwaseong-si, Gyeonggi-do 18447 (KR); KIM, Su Jin, Jeonggeup-si, Jeonbuk-do 56212 (KR); LEE, Yongsu, Jeonggeup-si, Jeonbuk-do 56212 (KR)
(74) Representative: Cabinet Beau de Loménie

(57) **Abstract**

The present disclosure relates to a semiconductor packaging alignment apparatus (100) and a method thereof, and the semiconductor packaging alignment apparatus includes a radiation source (120) that radiates radiation to a plurality of semiconductor chips, a radiation sensor (140) that detects the radiation passing through the plurality of semiconductor chips, a head (130) that is coupled with one of the radiation source or the radiation sensor, an alignment part (150) that aligns and bonds the plurality of semiconductor chips based on detection information acquired by the radiation sensor, and a process that controls at least one of the radiation source, the head, the radiation sensor, or the alignment part, or any combination thereof, wherein the processor (110) identifies a second semiconductor chip, which is to be coupled to a first semiconductor chip, among the plurality of semiconductor chips, based on identification of the first semiconductor chip, which is coupled to at least a portion of the head, among the plurality of semiconductor chips and controls at least one of the head, or the alignment part, or any combination thereof to match a first reference mark included in the first semiconductor chip and a second reference mark included in the second semiconductor chip.

## Description

### CROSS-REFERENCE TO RELATED APPLICATION

This application claims the benefit of priority to Korean Patent Application No. 10-2024-0065088, filed in the Korean Intellectual Property Office on May 20, 2024 and Korean Patent Application No. 10-2024-0141332, filed in the Korean Intellectual Property Office on October 16, 2024, the entire contents of which are incorporated herein by reference.

### TECHNICAL FIELD

The present disclosure relates to a chiplet head alignment apparatus equipped with an X-ray imaging system for aligning a semiconductor packaging and a method therefor.

### BACKGROUND

With the development of an artificial intelligence technology, research and development of artificial intelligence modules continue, and accordingly, research on miniaturization of a single chip through process miniaturization and a technology that may implement a multi-functional chip by packaging chips having various functions are being spotlighted in the field of the artificial intelligence module. Further, an advanced packing technology, which is represented by hybrid bonding for a vertical stacking technology of wafers or chips for securing a high capacity, is being actively developed.

To this end, 2.5D/3D integrated technologies using a silicon interposer and a TSV have been developed, but until now, if the semiconductor chips are bonded (during chip-to-chip bonding), a method of identifying a bonding location, remembering the bonding location, and performing mechanical bonding is used by an optical method. Alternatively, a method of recognizing an alignment mark outside a lower chip and aligning and attaching an upper chip onto the lower chip by a chiplet head equipped with an optical system is used.

### SUMMARY

The present disclosure has been made to solve the above-mentioned problems occurring in the prior art while advantages achieved by the prior art are maintained intact.

An aspect of the present disclosure provides a semiconductor package alignment apparatus for increasing accuracy of bonding, and accordingly, increasing a production yield of semiconductors by detecting a radiation source in a process of bonding a plurality of semiconductor chips and by continuously performing fine alignment on the semiconductor chips, and a method therefor.

Another aspect of the present disclosure provides a high-precision X-ray chip alignment head for a semiconductor chiplet, which may align an attachment surface of a semiconductor chip, which may not be visually identified, while visually identifying an interconnect or a TSV of attached upper/lower chips using X-rays, and an alignment method using the same.

Still another aspect of the present disclosure provides a semiconductor packaging alignment apparatus for relatively improving precision of alignment, increasing a packaging yield, and thus reducing production costs, and increasing price competitiveness compared to bonding based on an optical alignment method, and a method therefor.

Yet another aspect of the present disclosure provides a semiconductor packaging alignment device for preventing loss of an area of a lower chip by an alignment mark by an optical system located outside a chiplet head, increasing packaging integration, and thus reducing production costs, and increasing price competitiveness, and a method therefor.

Yet another aspect of the present disclosure provides a semiconductor packaging alignment apparatus capable of accurately bonding an interconnect or a TSV miniaturized as the number of bonding parts per area of an upper chip and a lower chip increases and thus increasing the yield of a semiconductor chip, and a method therefor.

Yet another aspect of the present disclosure provides a method that may be used even in a bump process according to the related art but may accurately detect a bonding part during hybrid bonding that is a next-generation technology which will be used if an interconnect or a TSV miniaturized as the number of bonding parts increases is bonded and thus improve a production yield and increase performance of a semiconductor.

Yet another aspect of the present disclosure provides a semiconductor chip packaging alignment apparatus for radiating low-dose radiation or transmitting radiation only to a partial area, in which an alignment mark and/or a TSV is located, rather than the entire area of a semiconductor chip, and thus preventing damage to the semiconductor chip, and a method therefor.

The technical problems to be solved by the present disclosure are not limited to the aforementioned problems, and any other technical problems not mentioned herein will be clearly understood from the following description by those skilled in the art to which the present disclosure pertains.

According to an aspect of the present disclosure, a semiconductor packaging alignment apparatus includes a radiation source that radiates radiation to a plurality of semiconductor chips, a head that is coupled to at least a portion of the radiation source and causes at least one of movement, or rotation, or any combination thereof of the radiation source, a radiation sensor that detects the radiation passing through the plurality of semiconductor chips, an alignment part that aligns and bonds the plurality of semiconductor chips based on detection information acquired by the radiation sensor, and a process that controls at least one of the radiation source, the head, the radiation sensor, or the alignment part, or any combination thereof, wherein the processor identifies a second semiconductor chip, which is to be coupled to a first semiconductor chip, among the plurality of semiconductor chips, based on identification of the first semiconductor chip, which is coupled to at least a portion of the head, among the plurality of semiconductor chips and controls at least one of the head, or the alignment part, or any combination thereof to match a first reference mark included in the first semiconductor chip and a second reference mark included in the second semiconductor chip.

### BRIEF DESCRIPTION OF THE DRAWINGS

The above and other objects, features and advantages of the present disclosure will be more apparent from the following detailed description taken in conjunction with the accompanying drawings:
FIG. 1 illustrates an example of a block diagram related to a semiconductor packaging chiplet alignment apparatus according to an embodiment of the present disclosure;
FIG. 2 is a schematic view illustrating an example of the semiconductor packaging chiplet alignment apparatus according to the embodiment of the present disclosure;
FIGS. 3A and 3B illustrate an example of arrangement of the semiconductor chip packaging alignment apparatus according to the embodiment of the present disclosure;
FIG. 4A illustrates an example of matching images of an alignment mark according to the embodiment of the present disclosure;
FIG. 4B illustrates an example of matching images of a TSV according to the embodiment of the present disclosure;
FIG. 5 illustrates an example of a flowchart related to a semiconductor packaging alignment method according to the embodiment of the present disclosure; and
FIG. 6 illustrates an example of the flowchart related to the semiconductor packaging alignment method according to the embodiment of the present disclosure.

### DETAILED DESCRIPTION

Hereinafter, some embodiments of the present disclosure will be described in detail with reference to the exemplary drawings. In adding reference numerals to components of each drawing, it should be noted that identical or equivalent components are designated by an identical numeral even if they are displayed on other drawings. Further, in describing the embodiment of the present disclosure, a detailed description of the related known configuration or function will be omitted if it is determined that the detailed description interferes with the understanding of the embodiment of the present disclosure.

Further, in describing the components of the embodiments of the present disclosure, terms, such as first, second, "A", "B", (a), and (b) may be used. These terms are merely intended to distinguish one component from other components, and the terms do not limit the nature, order, or sequence of the components. Unless otherwise defined, all terms including technical and scientific terms used herein include the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

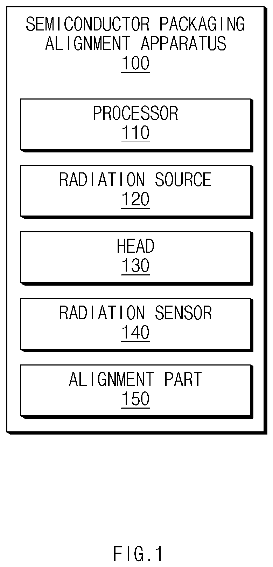

Hereinafter, embodiments of the present disclosure will be described in detail with reference to FIGS. 1 to 6.

FIG. 1 illustrates an example of a block diagram related to a semiconductor packaging chiplet alignment apparatus according to an embodiment of the present disclosure.

Referring to FIG. 1, a semiconductor packaging alignment apparatus 100 according to an embodiment of the present disclosure may include a processor 110, a radiation source 120, a head 130, a radiation sensor 140, and an alignment part 150. The processor 110, the radiation source 120, the head 130, the radiation sensor 140, or the alignment part 150 may be electrically and/or operatively connected to each other by an electronic component including a communication bus.

Hereinafter, operatively coupled hardware may include a state in which a direct connection and/or an indirect connection between the hardware is established by wire and/or wirelessly so that second hardware is controlled by first hardware among the hardware. Although different blocks are illustrated, an embodiment is not limited thereto.

The semiconductor packaging alignment apparatus 100 according to the embodiment may include hardware for processing data based on one or more instructions. The hardware for processing data may include the processor 110.

For example, the hardware for processing data may include an arithmetical and logical unit (ALU), a floating point unit (FPU), a field programmable gate array (FPGA), a central processing unit (CPU) and/or an application processor (AP). The processor 110 may include a structure of a single-core processor or may include a structure of a multicore processor including a dual core, a quad core, a hexa core, or an octa core.

The following description may include operations performed by controlling other hardware by the processor 110. For example, an operation in which the radiation source 120 radiates radiation may include an operation in which the radiation source 120 is controlled by the processor 110 to radiate the radiation. For example, the processor 110 may control at least one of the radiation source 120, the head 130, the radiation sensor 140, or the alignment part 150, or any combination thereof.

For example, the processor 110 may control at least one of the radiation source 120, the head 130, the radiation sensor 140, or the alignment part 150, or any combination thereof, to align a plurality of semiconductors arranged vertically with respect to a reference plane.

In the embodiment, the radiation source 120 may radiate radiation to a plurality of semiconductor chips. The radiation source 120 may include a device that emits radiation due to decay of radioactive elements or an X-ray generating device that allows at least one of materials, or accelerated electrons, or any combination thereof to collide with a target to generate X-rays. The semiconductor packaging alignment apparatus 100 may include a shielding body in the other directions except for a direction, in which the plurality of semiconductor chips are located, in order to radiate the radiation emitted from the radiation source 120 to the plurality of semiconductor chips.

For example, the plurality of semiconductor chips may include a semiconductor chip. For example, the semiconductor chip may include a volatile memory including at least one of a dynamic random access memory (DRAM), or a static random access memory (SRAM), or any combination thereof. For example, the semiconductor chip may include a non-volatile memory including at least one of a phase-change random access memory (PRAM), a magneto-respective random access memory (MRAM), a ferroelectric random access memory (FeRAM), or a resistive random access memory (RRAM), or any combination thereof.

For example, the alignment apparatus 100 may manufacture an artificial intelligence semiconductor by bonding a plurality of chips having different functions to a single parent chip. For example, the alignment apparatus 100 may manufacture a high bandwidth memory (HBM) by stacking single-layered memory semiconductors.

Each of the plurality of semiconductor chips may include a semiconductor device including a plurality of individual devices. The plurality of individual devices may include various microelectronic devices. For example, the plurality of individual elements may include a metal-oxide-semiconductor field effect transistor (MOSFET) including a complementary metal-oxide semiconductor (CMOS) transistor, a system large scale integration (LSI), an image sensor including a CMOS imaging sensor (CIS), a micro-electro-mechanical system (MEMS), an active element, and/or a passive element.

The plurality of semiconductor chips may include a logic semiconductor chip and/or a memory semiconductor chip. For example, the logic semiconductor chip may include an application processor (AP), a microprocessor, a central processing unit (CPU), a controller, a graphic processing unit (GPU), a neural processing unit (NPU), a high bandwidth memory (HBM), a field programmable gate array (FPGA), and/or an application specific integrated circuit (ASIC).

For example, the embodiments of the present disclosure may also be used in a process of connecting an upper chip to an interposer in a chip on wafer on substrate (CoWoS) process or a process of connecting the interposer, to which the upper chip is coupled, to a main substrate. The embodiments of the present disclosure may be utilized in a process of attaching various semiconductor chips, including a chip on chip (CoC) process and/or a chip on wafer (CoW) process, to at least one of another chip, the interposer, or a substrate, or any combination thereof.

For example, the radiation source 120 may include an X-ray source. The X-ray may include a wavelength of 0.01 nm to 10 nm. Since the X-ray includes little error caused by a thickness of the semiconductor chip and passes through penetrate the semiconductor chip, the radiation sensor 140 may detect radiation passing through the semiconductor chip. Thus, the semiconductor packaging alignment apparatus 100 may identify alignment of the semiconductor chips even in a semiconductor packaging process in nm units including µm units, and thus a defect rate due to alignment errors between the semiconductor chips may be reduced, and a yield rate may be dramatically increased.

In the embodiment, the head 130 may be coupled to at least a portion of the radiation source 120. For example, the head 130 may be coupled to the at least a portion of the radiation source 120 to cause at least one of movement or rotation of the radiation source 120, or any combination thereof.

In the embodiment, the head 130 and the radiation source 120 may be arranged to face each other. For example, the head 130 may be disposed above semiconductors to be aligned, and the radiation source 120 may be disposed below the semiconductors to be aligned. If the head 130 is disposed on an upper side and the radiation source 120 is disposed on a lower side, the radiation sensor 140 for detecting radiation by the radiation source 120 may be coupled to the head 130.

In the embodiment, the radiation sensor 140 may detect radiation passing through the plurality of semiconductor chips. The radiation sensor 140 may include a detector that detects radiation. For example, the radiation sensor 140 may detect radiation by detecting a change in a current and/or a voltage generated by collision with particles (e.g., photons) emitted from the radiation source 120.

For example, the plurality of semiconductor chips may be vertically arranged with respect to the reference plane. For example, the reference plane may include the ground. However, the embodiment of the present disclosure is not limited to the above description.

For example, the radiation source 120 may be located above an upper semiconductor chip located on an uppermost side among the plurality of semiconductor chips.

For example, the radiation sensor 140 may be located below a lower semiconductor chip located on a lowermost side among the plurality of semiconductor chips.

For example, the radiation sensor 140 may detect a current caused by collision with particles emitted from the radiation source 120. An integral value of the current detected by the radiation sensor 140 may be proportional to radiation energy incident on the radiation sensor 140.

In the embodiment, the radiation sensor 140 may acquire detection information based on the detected radiation passing through the plurality of semiconductor chips. For example, the detection information may include at least one of a coefficient rate of the radiation, or the radiation energy, or any combination thereof. However, the embodiment of the present disclosure is not limited to the above description.

For example, the radiation sensor 140 may detect the radiation in a specific area including the plurality of semiconductor chips. For example, the radiation sensor 140 may detect a coefficient rate of radiation particles incident on a detection point in a specific area. The plurality of semiconductor chips may be included in a phase area generated if light is vertically radiated to the plurality of semiconductor chips. For example, the radiation sensor 140 may generate visualized information (e.g., an image) based on the coefficient rate of each point if the phase area is generated by vertically radiating light to the plurality of semiconductor chips.

For example, the radiation sensor 140 may generate the visualized information using a shadow effect. For example, as the coefficient rate of the radiation sensor 140 becomes greater, a relatively large amount of radiation passes, and thus the corresponding area may be displayed in a color having a high brightness, and as the coefficient rate thereof becomes smaller, a relatively small amount of radiation passes, and thus the corresponding area may be displayed in a color having a low brightness. However, the embodiment of the present disclosure is not limited to the above description.

In the embodiment, the radiation sensor 140 may include a resolution in nm units including µm units.

In the embodiment, the processor 110 may control the head 130 by using the detection information acquired by the radiation sensor 140. For example, the processor 110 may align the plurality of semiconductor chips based on the control of the head 130 using the detection information.

The semiconductor packaging alignment apparatus 100 according to the embodiment may further include a lower plate located below the lower sem iconductor chip located on a lowermost side among the plurality of semiconductor chips and in contact with at least a portion of the lower semiconductor chip.

For example, the processor 110 may control the lower plate by using the detection information acquired by the radiation sensor 140. For example, the processor 110 may align the plurality of semiconductor chips based on the control of the lower plate using the detection information acquired by the radiation sensor 140.

For example, each of the plurality of semiconductor chips may include at least one of an alignment mark, or a through silicon via (TSV), or any combination thereof.

For example, the detection information may include location information associated with at least one of the alignment mark, or the TSV, or any combination thereof. For example, the at least one of the alignment mark, or the TSV, or any combination thereof may be formed of a material having a lower radiation transmittance than a specified value.

For example, the at least one of the alignment mark, or the TSV, or any combination thereof may be formed of a material including at least one of nickel, or tin, or any combination thereof and having a low X-ray transmittance and a high X-ray absorption rate.

In this case, if the radiation sensor 140 detects radiation passing through the plurality of semiconductor chips, radiation is not detected or is less detected in a portion corresponding to a location at which the alignment mark and/or the TSV is formed, and therefore the location information of the alignment mark and the TSV of each of the plurality of semiconductor chips 231 and 233 may be identified.

Accordingly, the semiconductor chip packaging alignment apparatus 100 may align the plurality of semiconductor chips 231 and 233 by matching locations of the alignment marks (or phases) or matching locations of the TSV (or phases). For example, the semiconductor packaging alignment apparatus 100 may align the plurality of semiconductor chips by controlling the head 130.

In the embodiment, the processor 110 may control the alignment part 150 based on the location information associated with the at least one of the alignment mark, or the TSV, or any combination thereof. For example, the processor 110 may align the plurality of semiconductor chips by controlling the alignment part 150 based on the location information associated with the at least one of the alignment mark, or the TSV, or any combination thereof.

In the embodiment, the processor 110 may match the phases of the alignment marks or match the phases of the TSVs based on the control of the alignment part 150 by using the location information associated with the at least one of the alignment mark, or the TSV, or any combination thereof. For example, the processor 110 may align the plurality of semiconductor chips by matching the phases of the alignment marks or matching the phases of the TSVs.

The semiconductor packaging alignment apparatus 100 according to the embodiment may further include a camera for acquiring images of the plurality of semiconductor chips.

For example, the camera may include one or more optical sensors (e.g., a charged coupled device (CCD) sensor and a CMOS sensor) that generate electrical signals indicating color and/or brightness of light. The plurality of optical sensors included in the camera may be arranged in the form of a two-dimensional array.

The camera may substantially simultaneously obtain the electrical signals of the plurality of optical sensors to generate images or frames corresponding to light reaching the optical sensors in the two-dimensional array and including a plurality of pixels arranged in two dimensions. For example, photo data captured using the camera may mean the plurality of images acquired from the camera.

In the embodiment, the processor 110 may control the radiation source 120 to radiate radiation to a designated area set based on the location of the at least one of the alignment mark, or the TSV, or any combination thereof obtained from the camera.

In the embodiment, the radiation source 120 may radiate radiation to the designated area set based on the location of the alignment mark and/or the TSV obtained from the camera.

For example, radiation may affect the semiconductor device included in the semiconductor chip due to an excitation phenomenon of at least some of electrons during a process of radiation transmission. The semiconductor device may correspond to a sensitive component, and thus, if radiation radiated from the radiation source 120 passes therethrough, there is a possibility that the semiconductor device may be damaged. Thus, the semiconductor packaging alignment apparatus 100 may prevent damage to the semiconductor chip by transmitting radiation to a partial area, in which the alignment mark and/or TSV is located, rather than the entire area of the semiconductor chip. The designated area set based on the location of the alignment mark and/or the TSV obtained from the camera may include the partial area in which the alignment mark and/or the TSV is located.

For example, the designated area may be differently set in the plurality of semiconductor chips and may be set to include the location in which the alignment mark and/or the TSV included in each of the plurality of semiconductor chips is formed. Each alignment mark and/or each TSV included in each of the plurality of semiconductor chips may be formed to include the same coordinates on a plane perpendicular to a direction in which the radiation is radiated.

The semiconductor packaging alignment apparatus 100 according to the embodiment may optically align the plurality of semiconductor chips based on locations of the plurality of semiconductor chips primarily photographed by the camera.

The semiconductor packaging alignment apparatus 100 according to the embodiment may further include a memory. For example, the memory may include a storage.

For example, the semiconductor packaging alignment apparatus 100 may store, in the memory, coordinate values indicating the location of each alignment mark and/or each TSV included in each of the plurality of semiconductor chips.

For example, the processor 110 of the semiconductor packaging alignment apparatus 100 may control the head 130 and/or the alignment part 150 to align the plurality of semiconductor chips based on the stored coordinate values indicating the location of the alignment mark and/or the TSV.

For example, the processor 110 may primarily align the plurality of semiconductor chips based on the coordinate values stored in the memory and finely align the plurality of semiconductor chips by using the radiation source 120.

The semiconductor packaging alignment apparatus 100 according to the embodiment may further include a display. For example, the display may provide the visualized information to a user. For example, the display may be controlled by at least one of the processor 110, or the GPU, or any combination thereof, to output the visualized information.

The semiconductor packaging alignment apparatus 100 according to the embodiment may further include a manipulation part for manipulating the alignment part 150. For example, the manipulation part may control the alignment part 150 based on reception of an input from the user. For example, the manipulation part may transmit a signal corresponding to the input to the processor 110 based on the reception of the input from the user. The processor 110, which receives the signal corresponding to the input, may control the alignment part 150.

For example, the processor 110 may output the detection information to the user through the display. For example, the processor 110 may control the alignment part 150 based on the input received from the manipulation part.

In the embodiment, the processor 110 may identify a first semiconductor chip, which is coupled to at least a portion of the head 130, among the plurality of semiconductor chips. For example, the processor 110 may identify a second semiconductor chip, which is to be coupled with the first semiconductor chip, among the plurality of semiconductor chips. For example, the processor 110 may identify the second semiconductor chip, which is to be coupled to the first sem iconductor chip, among the plurality of semiconductor chips, based on the identification of the first semiconductor chip, which is coupled to the at least a portion of the head 130, among the plurality of semiconductor chips.

For example, the radiation source 120 may detect the radiation passing through the plurality of semiconductor chips. for example, the head 130 may coupled with one of the radiation source or the radiation sensor.

In the embodiment, the processor 110 may control at least one of the head 130, or the alignment part 150, or any combination thereof to match a first reference mark included in the first semiconductor chip and a second reference mark included in the second semiconductor chip with each other. For example, the first reference mark may include at least one of a first alignment mark, or a first TSV, or any combination thereof. For example, the second reference mark may include at least one of a second alignment mark, or a second TSV, or any combination thereof.

In the embodiment, the processor 110 may control at least one of the head 130, or the alignment part 150, or any combination thereof to match the first TSV included in the first semiconductor chip and the second TSV included in the second semiconductor chip with each other. In another embodiment, the processor 110 may control at least one of the head 130, or the alignment part 150, or any combination thereof to match the first alignment mark included in the first semiconductor chip and the second alignment mark included in the second semiconductor chip with each other.

In the embodiment, the processor 110 may control at least one of the head 130, or the alignment part 150, or any combination thereof to couple (or attach) the first semiconductor chip and the second semiconductor chip based on the matching of at least one of the first TSV, or the first alignment mark, or any combination thereof included in the first sem iconductor chip and at least one of the second TSV, or the second alignment mark, or any combination thereof included in the second semiconductor chip with each other.

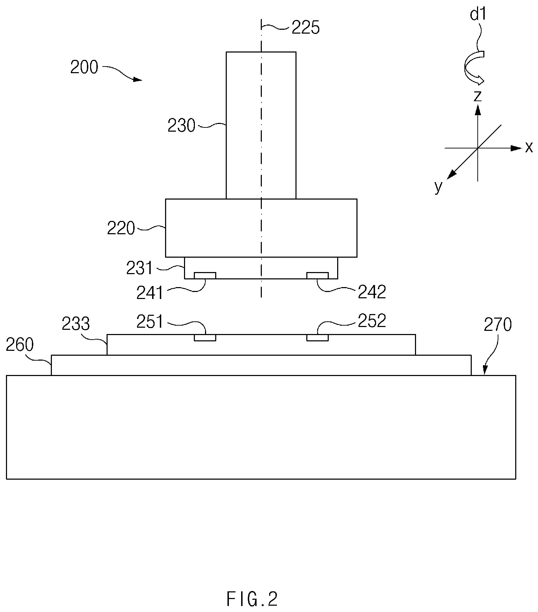

FIG. 2 is a schematic view illustrating an example of the semiconductor packaging chiplet alignment apparatus according to the embodiment of the present disclosure.

Referring to FIG. 2, a semiconductor packaging alignment apparatus 200 (e.g., the semiconductor packaging alignment apparatus 100 in FIG. 1) according to the embodiment may include a radiation source 220 and a head 230.

A processor (e.g., the processor 110 in FIG. 1) of the semiconductor packaging alignment apparatus 200 according to the embodiment may control an alignment part (e.g., the alignment part 150 in FIG. 1) to align the plurality of semiconductor chips 231 and 233.

For example, the processor may rotate the head 230 about an optical axis 225 of the radiation source 220 to align the plurality of semiconductor chips 231 and 233. Although it has been described that the head 230 rotates about the optical axis 225 of the radiation source 220, the embodiment is not limited thereto. For example, the processor may rotate the head 230 about a central axis of the head 230 to align the plurality of semiconductor chips 231 and 233.

For example, the processor may move the head 230 in at least one of the "x" axis, the "y" axis, or the "z" axis, or any combination thereof. For example, the processor may move the head 230 in at least one of the "x" axis, the "y" axis, or the "z" axis, or any combination thereof to align the plurality of semiconductor chips 231 and 233.

For example, the plurality of semiconductor chips 231 and 233 may include alignment marks 241, 242, 251, and 252.

For example, the processor may control the head 230 to match the first alignment mark 241 included in the first semiconductor chip 231 and the second alignment mark 251 included in the second semiconductor chip 233.

For example, the plurality of semiconductor chips 231 and 233 may be arranged vertically with respect to a reference surface 270. For example, the plurality of semiconductor chips 231 and 233 may be arranged vertically parallel to the reference plane 270.

For example, the processor may control the head 230 based on the detection information obtained by the radiation source 220 to align the plurality of semiconductor chips 231 and 233 arranged vertically with respect to the reference plane 270.

For example, the processor may control the head 230 to match the third alignment mark 242 included in the first semiconductor chip 231 and the fourth alignment mark 252 included in the second semiconductor chip 233.

For example, the processor may rotate the head 230 in a first direction d1. For example, the processor may rotate the head 230 in the first direction d1 to align the first semiconductor chip 231 and the second semiconductor chip 233. For example, the first direction d1 may include a direction in which the head 230 rotates counterclockwise based on a reference axis perpendicular to the reference plane 270 if viewed from the above. However, the embodiment of the present disclosure is not limited to the above description.

According to the embodiment, the semiconductor packaging alignment apparatus 200 may further include a lower plate 260. For example, the semiconductor packaging alignment apparatus 200 may control the lower plate 260 to align the first semiconductor chip 231 and the second semiconductor chip 233.

For example, the semiconductor packaging alignment apparatus 200 may control the lower plate 260 based on the detection information acquired by the radiation source 220 to align the first semiconductor chip 231 and the second semiconductor chip 233.

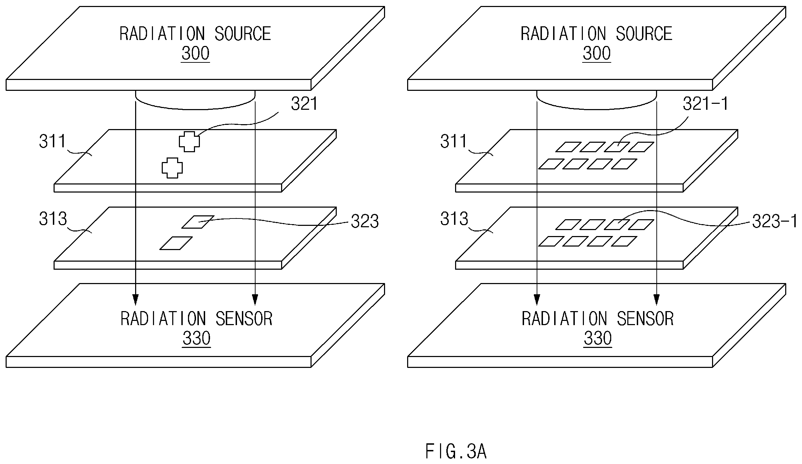

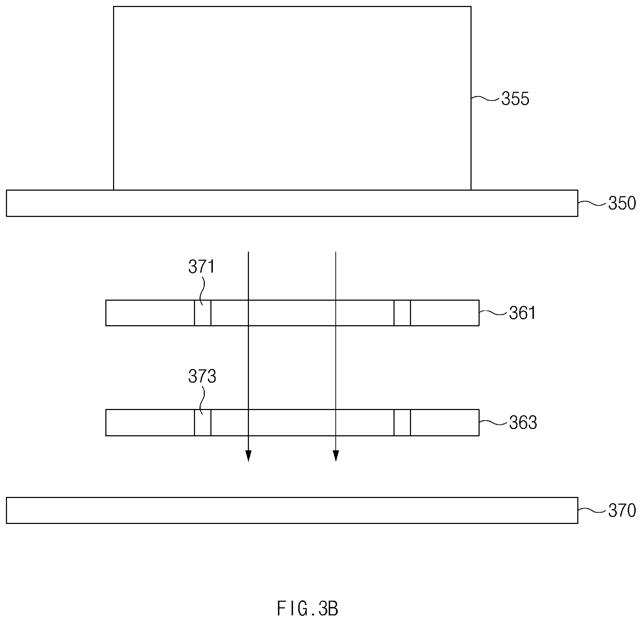

FIGS. 3A and 3B illustrate an example of arrangement of the semiconductor chip packaging alignment apparatus according to the embodiment of the present disclosure.

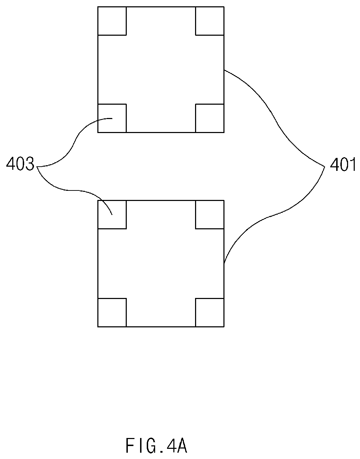

FIG. 4A illustrates an example of matching images of an alignment mark according to the embodiment of the present disclosure.

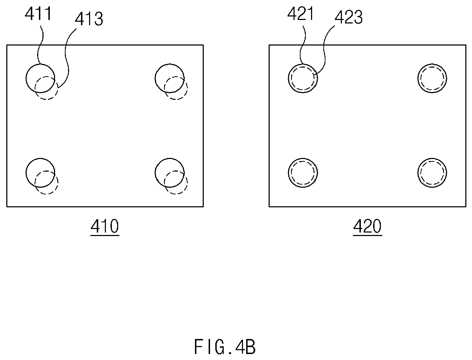

FIG. 4B illustrates an example of matching images of a TSV according to the embodiment of the present disclosure.

Referring to FIGS. 3A and 3B, the semiconductor packaging alignment apparatus (e.g., the semiconductor packaging alignment apparatus 100 in FIG. 1 and/or the semiconductor packaging alignment apparatus 200 in FIG. 2) may align a plurality of semiconductor chips 311, 313, 361, and 363 in a state in which the plurality of semiconductor chips 311, 313, 361, 363 are vertically arranged.

For example, among the plurality of semiconductor chips 311, 313, 361, and 363, the first semiconductor chip 311 may be disposed closer to a radiation source 300 than the second semiconductor chip 313. For example, among the plurality of semiconductor chips 311, 313, 361, and 363, the second semiconductor chip 313 may be disposed closer to a radiation sensor 330 than the first semiconductor chip 311.

For example, each of the plurality of semiconductor chips 311, 313, 361, and 363 may include at least one of an alignment mark, or a TSV, or any combination thereof. For example, all of the plurality of semiconductor chips 311, 313, 361, and 363 may include the alignment marks or all of the plurality of semiconductor chips 311, 313, 361, and 363 may include the TSVs.

For example, the alignment mark may include a mark formed in a specific area of each of the semiconductor chips to align the plurality of semiconductor chips 311, 313, 361, and 363.

For example, the TSV may include a through-hole formed so that the semiconductor chips are electrically connected if semiconductor chips are bonded. The TSV may be connected to an electrode inside the plurality of semiconductor chips 311, 313, 361, and 363 through fine holes in the plurality of semiconductor chips 311, 313, 361, and 363 to transmit an electrical signal. The at least one of the alignment mark, or the TSV, or any combination thereof may be generated in a process including an exposure process and/or a deposition process before a packaging process using the semiconductor chip packaging alignment apparatus. However, the embodiment of the present disclosure is not limited to the above description.

The at least one of the alignment mark, or the TSV, or any combination thereof may be formed at a specific location of each of the plurality of semiconductor chips 311, 313, 361, and 363 to align the plurality of semiconductor chips 311, 313, 361, and 363. For example, the semiconductor packaging alignment apparatus may form the alignment marks so that the plurality of semiconductor chips 311, 313, 361, and 363 are aligned if the locations of the alignment marks (or the phases of the alignment marks) are matched. For example, the semiconductor packaging alignment apparatus may form the TSVs so that the plurality of semiconductor chips 311, 313, 361, and 363 are aligned if locations of the TSVs (or the phases of the TSVs) are matched.

Referring to FIG. 3A, the first semiconductor chip 311 may include a first alignment mark 321. The second semiconductor chip 313 may include a second alignment mark 323.

The first alignment mark 321 and the second alignment mark 323 may include shapes that complement each other to identify whether a location of the first alignment mark 321 and a location of the second alignment mark 323 are matched with each other. As an example, in FIG. 4A, a first alignment mark 401 may include a cross shape, and a second alignment mark 403 may include a quadrangular shape. For example, the processor may determine whether a phase of the first alignment mark 321 is in contact with a phase of the second alignment mark 323 and control a head (e.g., the head 130 in FIG. 1 and/or the head 230 in FIG. 2) to align locations of the first semiconductor chip 311 and the second semiconductor chip 313.

For example, the first semiconductor chip 311 may include an interconnect or a TSV 321-1. For example, the second semiconductor chip 313 may include an interconnect or a TSV 323-2.

For example, the processor may align the first semiconductor chip 311 and the second semiconductor chip 313 using the interconnect or the TSV 321-1 of the first semiconductor chip 311 and the interconnect or the TSV 323-1 of the second semiconductor chip 313 as reference marks.

Referring to FIG. 3B, the first semiconductor chip 361 may include a first TSV 371. The second semiconductor chip 363 may include a second TSV 373. For example, the first TSV 371 and the second TSV 373 may be formed at substantially the same location to vertically connect the first TSV 371 and the second TSV 373, and thus align the first semiconductor chip 361 and the second semiconductor chip 363. As an example, in FIG. 4B, the first TSV and the second TSV may include a cylindrical structure. For example, if viewed from the outside, the cylindrical structure may be formed in a quadrangular shape or a circular shape, and a shape thereof is not limited thereto.

Referring back to FIG. 3B, for example, a phase of the first TSV 371 detected by a radiation sensor 370 and a phase of the second TSV 373 may overlap each other. For example, based on radiation radiated from the radiation source 350 and passing through the first semiconductor chip 361 and the second semiconductor chip 363 and the detection information obtained by the radiation sensor 370, the processor may control the head to align the first semiconductor chip 361 and the second semiconductor chip 363. In FIG. 3B, the radiation sensor 370 is described, but the semiconductor packaging alignment apparatus may include a lower plate including the radiation sensor 370, and a detector may be included in the lower plate.

For example, the alignment apparatus may include a head 355. For example, the head 355 may be referred to as a chiplet head. For example, the head 355 may include a radiation source or a detector.

Referring to FIG. 4B, a first example 410 may include an example in which a first connection part 411 including a first interconnect and/or the first TSV and a second connection part 413 including a second interconnect and/or the second TSV are not aligned. A second example 420 may include an example in which the first connection part 421 and the second connection part 423 are aligned.

In the embodiment, the processor of the alignment apparatus may change a state of the first connection part 411 and the second connection part 413 from a not-aligned state to an aligned state and may bond the semiconductor chips in the changed state.

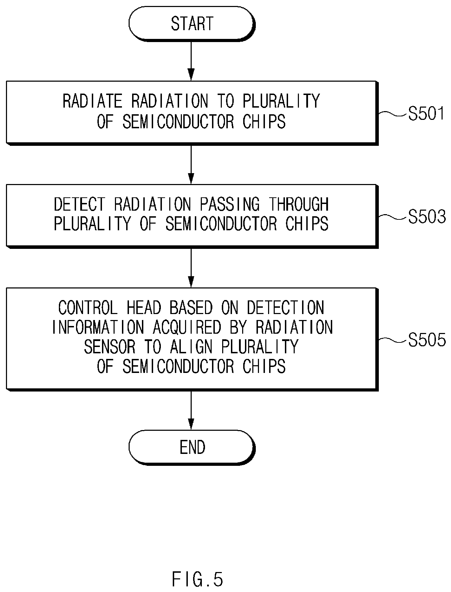

FIG. 5 illustrates an example of a flowchart related to a semiconductor packaging alignment method according to the embodiment of the present disclosure.

Hereinafter, it is assumed that the semiconductor packaging alignment apparatus 100 of FIG. 1 performs a process of FIG. 5. Further, in the description of FIG. 5, it may be understood that an operation described as being performed by the apparatus is controlled by the processor 110 of the semiconductor packaging alignment apparatus 100.

At least one of operations of FIG. 5 may be performed by the semiconductor packaging alignment apparatus 100 of FIG. 1. At least one of the operations of FIG. 5 may be controlled by the processor 110 of FIG. 1. The operations of FIG. 5 may be performed sequentially but is not necessarily performed sequentially. For example, orders of the operations may be changed, and at least two operations may be performed in parallel.

Referring to FIG. 5, in operation S501, a semiconductor packaging alignment method according to the embodiment may include an operation of radiating radiation to the plurality of semiconductor chips.

For example, the semiconductor packaging alignment method may include an operation of radiating radiation to the plurality of semiconductor chips using a radiation source.

In operation S503, the semiconductor packaging alignment method according to the embodiment may include an operation of detecting radiation passing through the plurality of semiconductor chips.

In operation S505, the semiconductor packaging alignment method according to the embodiment may include an operation of aligning and bonding the plurality of semiconductor chips by controlling a head based on detection information acquired by a radiation sensor.

For example, the semiconductor packaging alignment method may include an operation of aligning the plurality of semiconductor chips by controlling the head that is coupled to at least a portion of the radiation source to cause rotation of the radiation source.

For example, the semiconductor packaging alignment method may include an operation of aligning the plurality of semiconductor chips by controlling the head coupled to the at least a portion of the radiation source to cause the rotation of the radiation source or a lower plate (e.g., a stage) on which the plurality of semiconductor chips are arranged.

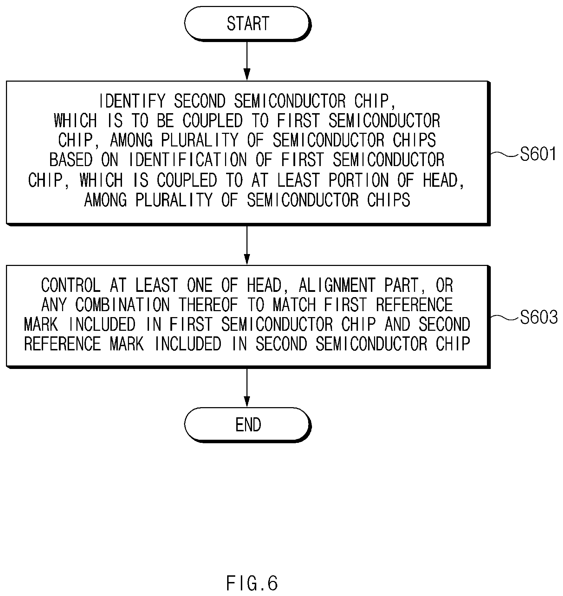

FIG. 6 illustrates an example of the flowchart related to the semiconductor packaging alignment method according to the embodiment of the present disclosure.

Hereinafter, it is assumed that the semiconductor packaging alignment apparatus 100 of FIG. 1 performs a process of FIG. 6. Further, in the description of FIG. 6, it may be understood that an operation described as being performed by the apparatus is controlled by the processor 110 of the semiconductor packaging alignment apparatus 100.

At least one of operations of FIG. 6 may be performed by the semiconductor packaging alignment apparatus 100 of FIG. 1. At least one of the operations of FIG. 6 may be controlled by the processor 110 of FIG. 1. The operations of FIG. 6 may be performed sequentially but is not necessarily performed sequentially. For example, orders of the operations may be changed, and at least two operations may be performed in parallel.

Referring to FIG. 6, in operation S601, the semiconductor packaging alignment method according to the embodiment may include an operation of identifying the second semiconductor chip, which is to be coupled to the first semiconductor chip, among the plurality of semiconductor chips, based on the identification of the first semiconductor chip, which is coupled to the at least a portion of the head, among the plurality of semiconductor chips.

For example, the first semiconductor chip, which is coupled to the at least a portion of the head, among the plurality of semiconductor chips may include the first reference mark. For example, the first reference mark may include the at least one of the first alignment mark, or the first TSV, or any combination thereof.

For example, each of the plurality of semiconductor chips may include at least one of an alignment mark, a TSV, a fan-in interconnect or a fan-out interconnect, or an interposer interconnect, or any combination thereof.

For example, the second semiconductor chip among the plurality of semiconductor chips may include the second reference mark. For example, the second reference mark may include the at least one of the second alignment mark, or the second TSV, or any combination thereof.

In operation S603, the semiconductor packaging alignment method according to the embodiment may include an operation of controlling at least one of the head, or the alignment part, or any combination thereof to match the first reference mark included in the first semiconductor chip and the second reference mark included in the second semiconductor chip.

For example, the semiconductor packaging alignment method may include an operation of moving or rotating the head. For example, the head may be moved on a plane parallel to a surface on which the second semiconductor chip is disposed. For example, the head may rotate about the central axis of the head. For example, the head may be controlled by at least one of the semiconductor packaging alignment apparatus, or the processor included in the semiconductor packaging alignment apparatus, or any combination thereof and thus rotate about a center of the head or move on the plane parallel to the surface on which the second semiconductor chip is disposed.

Further, the head may include the radiation source. For another example, the head may be coupled to the at least a portion of the radiation source. For example, the head may include the radiation source to help generate data for determining whether the first semiconductor chip and the second semiconductor chip are matched with each other. For example, the semiconductor packaging alignment method may include an operation of determining whether the at least one of the first alignment mark, or the first TSV, or any combination thereof included in the first semiconductor chip and the at least one of the second alignment mark, or the second TSV, or any combination thereof included in the second semiconductor chip are matched with each other using the radiation source included in the head or coupled to the at least a part of the head.

For example, if the first reference mark and the second reference mark are not matched with each other, the semiconductor packaging alignment method may include an operation of controlling the head to match the first reference mark and the second reference mark.

For example, if the at least one of the first alignment mark, or the first TSV, or any combination thereof and the at least one of the second alignment mark, or the second TSV, or any combination thereof are not matched, the semiconductor packaging alignment method may include an operation of controlling the head to match the at least one of the first alignment mark, or the first TSV, or any combination thereof and the at least one of the second alignment mark, or the second TSV, or any combination thereof.

For example, the semiconductor packaging alignment method may include an operation of matching the first alignment mark included in the first semiconductor chip and the second alignment mark included in the second semiconductor chip by moving or rotating the head to which the first semiconductor chip is coupled (or attached).

For example, the semiconductor packaging alignment method may include an operation of matching the first TSV included in the first sem iconductor chip and the second TSV included in the second semiconductor chip by moving or rotating the head to which the first semiconductor chip is coupled (or attached).

For example, the semiconductor packaging alignment method may include an operation of identifying the at least one of the first alignment mark, or the first TSV, or any combination thereof included in the first semiconductor chip. For example, the semiconductor packaging alignment method may include an operation of identifying the at least one of the second alignment mark, or the second TSV, or any combination thereof included in the second semiconductor chip.

For example, the semiconductor packaging alignment method may include an operation of adjusting the head to match the first alignment mark and the second alignment mark.

For example, the semiconductor packaging alignment method may include an operation of adjusting the head to match the first TSV and the second TSV.

For example, the operation of adjusting the head may include an operation of rotating the head about the central axis of the head or moving the head.

As described above, the semiconductor packaging alignment method according to the embodiment may include an operation of identifying whether the at least one of the first alignment mark, or the first TSV, or any combination thereof included in the first semiconductor chip and the at least one of the second alignment mark, or the second TSV, or any combination thereof included in the second semiconductor chip are matched with each other using the radiation source included in the head or coupled to the head.

If the at least one of the first alignment mark, or the first TSV, or any combination thereof and the at least one of the second alignment mark, or the second TSV, or any combination thereof are not matched, the semiconductor packaging alignment method may include an operation of controlling the head, to which the first semiconductor chip is coupled, to match the at least one of the first alignment mark, or the first TSV, or any combination thereof and the at least one of the second alignment mark, or the second TSV, or any combination thereof. For example, the semiconductor packaging alignment method may include an operation of coupling the first semiconductor chip and the second semiconductor chip based on the matching of the at least one of the first alignment mark, or the first TSV, or any combination thereof and the at least one of the second alignment mark, or the second TSV, or any combination thereof. The semiconductor packaging alignment method may include an operation of aligning and coupling (or attaching) the first semiconductor chip and the second semiconductor chip by performing the above-described operation.

The semiconductor packaging alignment apparatus may be implemented as a hardware component, a software component, and/or a combination of a hardware component and a software component. For example, the devices and components described in the embodiments may be implemented using one or more general-purpose computers or special-purpose computers, such as a processor, a controller, a arithmetical logic unit (ALU), a digital signal processors, a microcomputer, a field programmable gate array (FPGA), a programmable logic unit (PLU), a microprocessor, or any other devices capable of executing and responding to instructions. A processing device may perform an operating system (OS) and one or more software applications running on the operating system. Further, the processing device may access, store, manipulate, process, and generate data in response to execution of software. For convenience of understanding, it is described that one processing device is used. However, those skilled in the art may know that the processing device may include a plurality of processing elements and/or a plurality of types of processing elements. For example, the processing device may include a plurality of processors or one processor and one controller. Further, the processing device may be other processing configurations such as a parallel processor.

The software may include a computer program, a code, an instruction, or a combination of one or more thereof, and may configure the processing device to be operated as desired or may independently or collectively command the processing device. Software and/or data may be interpreted by the processing device or embodied in any type of machine, a component, a physical device, a computer storage medium, or a device to provide instructions or data to the processing device. The software may be distributed over a networked computer system and stored or executed in a distributed manner. The software and the data may be stored in one or more computer-readable recording media.

The method according to the embodiment may be implemented in the form of a program instruction that may be executed through various computer means and recorded on a computer-readable medium. In this case, the medium may continuously store a computer-executable program or may temporarily store the computer-executable program for execution or download. Further, the medium may be various recording means or various storage means in the form of a single hardware or coupled several pieces of hardware, and is not limited to medium directly connected to any computer system, but may be distributed on a network. Examples of the medium may include a magnetic medium such as a hard disc, a floppy disc and a magnetic tape, optical recording medium such as a CD-ROM and a DVD, a magnetic-optical medium, such as a floptical disc, and a ROM, a RAM, a flash memory, and the like and may be configured to store program instructions. Further, other examples of the medium may include a recording medium or a storage medium managed by App stores that distribute applications, sites that supply or distribute various other software, a server, and the like.

According to the present disclosure, an interconnect or a TSV of a bonding surface, which may not be visually identified in a process of bonding a plurality of semiconductor chips, may be detected using a radiation source, fine alignment on the semiconductor chips may be continuously performed, accuracy of bonding may be increased, and accordingly, a production yield of a semiconductor may be increased.

Further, according to the present disclosure, precision of alignment may be relatively improved, a packaging yield may be increased, and thus production costs may be reduced, and price competitiveness may be increased as compared to bonding based on an optical alignment method.

Further, according to the present disclosure, low-dose radiation may be radiated or radiation may be transmitted only to a partial area, in which an alignment mark and/or a TSV is located, rather than the entire area of a semiconductor chip, and thus damage to the semiconductor chip may be prevented.

Further, according to the present disclosure, an alignment mark area of a lower chip for an alignment optical system mounted outside a chiplet head according to the related art may be reduced, and thus an integration degree of a chip may be increased.

In addition, various effects directly or indirectly identified though the present document may be provided.

As described above, the embodiments have been described by the limited embodiments and the accompanying drawings, but those skilled in the art may derive various modifications and changes from the above description. For example, even though the described technologies are performed in an order different from the described method, and/or the described components such as a system, a structure, a device, and a circuit are coupled or combined in a form different from the described method or are replaced or substituted by other components or equivalents, appropriate results may be achieved. Therefore, other implementations, other embodiments, and those equivalent to the appended claims also belong to the scope of the appended claims.

## Claims

1. A semiconductor packaging alignment apparatus (100, 200) comprising:
a radiation source (120, 220, 300, 350) configured to radiate radiation to a plurality of semiconductor chips (231, 233, 311, 313, 361, 363);
a radiation sensor (140, 330, 370) configured to detect the radiation passing through the plurality of semiconductor chips;
a head (130, 230, 355) coupled with one of the radiation source or the radiation sensor;
an alignment part (150) configured to align and bond the plurality of semiconductor chips based on detection information acquired by the radiation sensor; and
a processor (110) configured to control at least one of the radiation source, the head, the radiation sensor, or the alignment part, or any combination thereof,
wherein the processor is configured to:
identify (S601) a second semiconductor chip, which is to be coupled to a first semiconductor chip, among the plurality of semiconductor chips, based on identification of the first semiconductor chip, which is coupled to at least a portion of the head, among the plurality of semiconductor chips; and
control (S603) at least one of the head, or the alignment part, or any combination thereof to match a first reference mark included in the first semiconductor chip and a second reference mark included in the second semiconductor chip.

2. The semiconductor packaging alignment apparatus (200) of claim 1, further comprising:
a lower plate (260) located below a lower semiconductor chip, which is located on a lowermost side, among the plurality of semiconductor chips and in contact with at least a portion of the lower semiconductor chip (233),
wherein the processor is configured to align the plurality of semiconductor chips (231, 233) based on control of the lower plate using the detection information.

3. The semiconductor packaging alignment apparatus of claim 1 (200), wherein each of the plurality of semiconductor chips includes at least one of an alignment mark (241, 242, 251, 252, 321, 323, 401, 403), a through silicon via TSV (321-1, 323-2, 371, 373), a fan-in interconnect or a fan-out interconnect, or an interposer interconnect, and any combination thereof.

4. The semiconductor packaging alignment apparatus of claim 3, wherein the detection information includes location information associated with at least one of the alignment mark, or the TSV, or any combination thereof, and
wherein the processor is configured to control the alignment part based on the location information to align the plurality of semiconductor chips.

5. The semiconductor packaging alignment apparatus of claim 4, wherein the processor is configured to match a phase of the alignment mark or match a phase of the TSV based on the control of the alignment part using the location information to align the plurality of semiconductor chips.

6. The semiconductor packaging alignment apparatus of claim 3, wherein at least one of the alignment mark, or the TSV, or any combination thereof is formed of a material having a transmittance of the radiation lower than a specified value.

7. The semiconductor packaging alignment apparatus of claim 3, further comprising:
a camera configured to acquire images of the plurality of semiconductor chips,
wherein the processor is configured to control the radiation source to radiate the radiation to a designated area set based on location of at least one of the alignment mark, or the TSV, or any combination thereof, which are acquired from the camera.

8. The semiconductor packaging alignment apparatus of claim 1, wherein the plurality of semiconductor chips are vertically arranged with respect to a reference surface,
wherein the radiation source is located above an upper semiconductor chip, which is located on an uppermost side, among the plurality of semiconductor chips, and
wherein the radiation sensor is located below a lower semiconductor chip, which is located on a lowermost side, among the plurality of semiconductor chips.

9. The semiconductor packaging alignment apparatus of claim 1, further comprising:
a display; and
a manipulation part configured to manipulate the alignment part,
wherein the processor is configured to:
output and provide the detection information to a user through the display; and
control the alignment part based on input received from the manipulation part.

10. The semiconductor packaging alignment apparatus of claim 1, wherein the radiation source includes an X-ray source.

11. The semiconductor packaging alignment apparatus of claim 1, wherein the radiation sensor includes a resolution in nm units including µm units.

12. A semiconductor packaging alignment method comprising:
Radiating (S501), by a processor, radiation to a plurality of semiconductor chips;
detecting (S503) the radiation passing through the plurality of semiconductor chips;
controlling (S505) a head based on detection information acquired by a radiation sensor to align and bond the plurality of semiconductor chips;
identifying (S601) a second semiconductor chip, which is to be coupled to a first semiconductor chip, among the plurality of semiconductor chips, based on identification of the first semiconductor chip, which is coupled to at least a portion of the head, among the plurality of semiconductor chips, in order to align the plurality of semiconductor chips; and
controlling (S603) at least one of the head, or an alignment part, or any combination thereof to match a first reference mark included in the first semiconductor chip and a second reference mark included in the second semiconductor chip.
